# EUROPEAN PATENT SPECIFICATION

(11) **EP 2 573 829 B1**
(45) Date of publication and mention of the grant of the patent: **22.04.2020**
(21) Application number: 12198155.9
(22) Date of filing: 16.10.2007
(51) Int. Cl.: H01L 33/48, H01L 33/50, H01L 33/60, H01L 33/56

(54) **Light emitting diode module**
Leuchtdiodenmodul
Module de diode électroluminescente

(30) Priority: 20.10.2006 EP 06022064
(43) Date of publication of application: 27.03.2013
(62) Divisional of application: 07819030.3
(73) Proprietor: Tridonic Jennersdorf GmbH, 8380 Jennersdorf (AT); Lumitech Patentverwertung GmbH, 8380 Jennersdorf (AT)
(72) Inventor: Schrank, Franz, 8047 Raab (AT); Hoschopf, Hans, 8380 Jennersdorf (AT)
(74) Representative: Rupp, Christian

(56) References cited:
- EP-A2- 0 854 523
- WO-A1-98/23427
- WO-A1-2006/048064
- DE-C1- 10 245 946
- JP-A- 2006 066 786
- US-A- 5 851 847
- US-A1- 2003 173 655

## Description

The present invention relates to the field of light emitting diode (LED) modules comprising a LED chip mounted on a board, and a cover. The cover is designed to allow the directed passage of light to and/or from the component.

From the state of the art it is known to cover so called COB (chip-on-board) LED modules with a so called globe-top which is based on a heat-curable resin. Such a globe-top is usually applied with a standard dispensing equipment. However, the performance of LED modules having such a globe-top is not satisfying all requirements of different application fields. One of the main disadvantages actually is the directive characteristics, i.e. the wide emission angle, which is not well suited for using such a LED module with secondary optics, such as for example lenses or light guides.

In order to have a smaller emission angle of the light emitted by COB LED modules the LED chip is sometimes placed in a cavity with a reflecting wall. However, due to the spherical shape of the top surface of the globe-top, the contribution of the reflecting wall on the emission angle is not satisfying.

The second disadvantage of the globe-top cover is the low mechanical stability of the LED modules which is a disadvantage for the handling and mounting of the LED modules. In this context is to be noted that based on the requirements on a high UV stability, usually silicones are used as resins for the globe-top. Unfortunately, these rubber-like materials apply a high mechanical stress to bond wires if the spherical shape of the globe-top is warped.

WO 2006/017484A1 proposes a dam-and-fill technology in order to protect parts of a printed circuit board against electric short circuits.

DE 10245946 C1 discloses a LED module, wherein a reflecting potting material and a transparent potting material are filled successively into a temporary frame put around a LED chip. US 5851847 A discloses another LED module comprising a LED chip mounted on a board and a cover comprising an outer dam made from a silicone resin and a central filling made from a silicone resin, wherein the resin of the outer dam and the resin of the central filling are simultaneously cured thereby chemically linking the outer dam and the central filling across the interface between the two materials.

JP 2006066786 A discloses another LED module comprising a LED chip mounted on a board and a cover comprising an outer dam made from a silicone resin and a central filling made from a silicone resin, wherein the central filling comprises colour conversion particles. EP 0854523 A2 discloses another LED module comprising a package made from epoxy resin and including a recess surrounding a LED chip mounted therein and a transparent silicone resin filled into the recess, wherein the package comprises reflecting particles.

Therefore, it is the object of the present invention to propose an improved cover for LED modules, which cover allows the directed passage of light from the LED chip.

This object is achieved by means of the features of independent claim 1. The dependent claims develop further the central idea of the present invention.

According to the present invention, the cover comprises an outer non-transparent and reflective dam and a central filling, which central filling has been filled into the outer dam after the manufacturing of the outer dam. The outer dam and the central filling are respectively made from a cured resin and a cured transparent silicone based resin. The central filling is chemically linked to the outer dam across the interface between the two materials.

Note that "outer dam" does not represent any limitation as to the shape, as long as the dam can act as a dam surrounding the central filling and being stable in shape even in the uncured state.

The resin of the outer dam can be e.g. silicone.

The outer dam comprises reflecting particles such as for example white pigments. The reflecting particles are present throughout the bulk of the outer dam material. The dam thus has the role of a reflector applied in the liquid state on a board.

The outer dam can comprise 10 to 60 weight % of the reflecting particles.

The resin of the outer dam and the central filling can have the same chemical structure, e.g. they can be chemically identical.

The resin of the outer dam can be selected to have a storage modulus of more than 1000 Pa before being cured.

The resin of the outer dam can be selected such that it has for example a viscosity of more than 100 Pa*s when measured at a shear rate of 1 1/s, again before being cured.

The material of the outer dam can comprise particulate material such as e.g. silica, which particular material or fine grained material can be used in order to set the desired rheological properties of the uncured dam resin.

The height of the outer dam can be equal to or more than 1 mm.

The mean thickness of the outer dam can be selected according to the requirements of the final element. For a diameter of approx. 5 mm the thickness can be equal to or less than 0.5 mm. For larger diameters the thickness is adjusted to more than 0.5 mm, for smaller diameters the thickness might be less than 0.5 mm.

The inner diameter of the dam can be as small as e.g. 0.1 to 1 mm.

The cover comprises an outer dam and a central filling, which has been filled into the outer dam and at least partially on top of the LED chip after the outer dam has been made on the board surrounding the LED chip.

The central filling is made from a transparent silicone resin.

The central filling comprises color conversion particles which convert light emitted from the LED chip into light of a second, lower frequency spectrum.

The inner wall of the outer dam can be distanced from the LED chip, such that the distance between the outer dam and the LED chip is filled with the central filling which thus is also in contact with the board on which the LED chip is mounted e.g. in a chip-on-board technology.

The central filling can fill the entire volume defined by the outer dam such that the top surface of the filling is on the same level as the maximum height of the outer ring.

Preferably the outer dam raises higher from the board than the LED-chip.

The outer dam made from a liquid resin is first dispensed. This outer dam is then filled with a liquid silicone based transparent resin. Finally, in one single step, the resin of the outer dam and the resin of the central filling are cured and chemically linked across the interface between the outer dam and the central filling which guarantees a stronger adhesion between the central filling and the outer dam.

Further aspects, advantages and objects of the present invention will become evident from the following detailed explanation of embodiments of the present invention when taking in conjunction with the figures of the enclosed drawings.
Fig. 1 shows schematically a side view of a LED module according to the present invention.
Fig. 2 shows a top view of a LED module according to the present invention.
Fig. 3 shows a perspective view of a LED module according to the present invention.
Fig. 4 shows the use of a cover together with a light-erasable storage device (not forming part of the present invention), and
Fig. 5 shows the use of the LED module of the present invention in connection with a light guiding element.

As the cover has a role as an optical element, its precision has to go far beyond the precision necessary for purely protective purposes as known from WO 2006/017484A1.

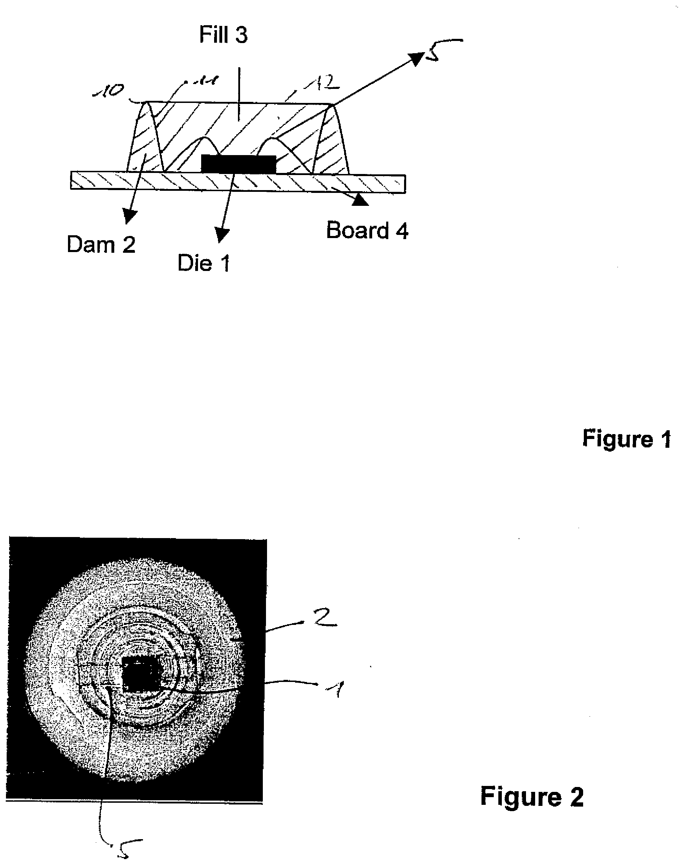

The following method will be explained in the context of producing a LED module as shown in Fig. 1.

In a first step, a ring-shaped dam (torus) of a liquid resin is dispensed around the LED chip 1, which is mounted on a board 4.

Preferably a plane board without recessions is used, as the reflective effect of walls of a recession can be achieved by the dam walls.

Dispensing techniques for resins and silicones are known as such from the prior art. Due to the dispensing technique the cross-sectional view of the dam tapers to the peak 10 of the dam 2. Thus the inner face 11 of dam 2 is inclined and preferably is steeper at its upper part which can be of advantage for reflection purposes.

The cross-sectional shape of the dam 2 can be controlled by the diameter of the dispensing needle used, the flow characteristics of the liquid dam material and the flow (dispensing) speed.

In the example shown in Fig. 1 the LED chip 1 is mounted according to the chip-on-board (COB) technology. The bond wires are designated with the reference numeral 5.

The wall of liquid resin is dispensed on the board 4 around the LED die 1 thus forming a dam.

The dam material is non-transparent for the wavelength of the light passing through the central filling inside the dam (see later on).

Please note that 'dam' in the context of the present description and claims does not constitute any limitation as to the contour of the walls, i.e. the dam does not necessarily have a spherical shape, but can e.g. have the shape of a square, an oval, a rectangular shape etc..

The circular shape is preferred if only a single LED chip is placed inside the dam (see later on), while a rectangular or oval shape is preferred in case a plurality of LED chips are placed inside the dam in a row configuration.

Different base resins can be used for the dam 2. Preferred materials are silicones due to their high UV stability.

The rheological characteristics of the liquid resin material for building the wall of the dam 2 have to be well selected such that after the dispensing the uncured resin is stable in shape until it is cured.

To this regard the storage modulus should be rather high and e.g. be at least 1000 Pa. The loss factor should be approximately 0.5.

The viscosity of the liquid resin should preferably be higher than 200 Pa*s (when measured at a shear rate of 1 1/s). A liquid resin material of such characteristics is suited for achieving a wall e.g. with a height of more than 1mm and a mean thickness of less than 0.5 mm.

In order to adjust the rheological characteristics of the liquid resin material, silica or other particulate material (fine grained material) can be added to the liquid resin.

As can be seen from Fig. 1, preferably the wall of the dam 2 is distanced from the LED die 1.

Furthermore, the height of the dam 2 is set to be higher than the height of the LED die 1. E.g. the height of the dam 2 can be twice or three times the height of the LED die 1.

In order to provide light reflectivity of the wall of the dam 2, reflecting substances such as e.g. white pigments are added into the liquid resin material. Examples for such pigments are pigments made from TiO₂, BaTiO₃, BaSO₄ and/or ZrO₂.

Preferably, these pigments are added to the liquid resin in an amount of 10% to 60% per weight.

Thus the entire material of the dam will have a non-transparent and preferably white reflecting appearance. The reflection from light from the LED die 1 occurs at the inner face 11 of the dam 2 reflecting light back to the interior of the dam 2 and away from the LED die 1.

In a second step the volume confined by the inner walls of the self-stable dam 2 is filled with a liquid transparent resin filling material. As can be seen from Fig. 1, this filling is preferably made such that the top level of the filling flushes with the top level of the walls of the dam 2. Due to the filling with the liquid resin the top surface 12 of the central filling 3 will be preferably flat.

To summarize, liquid uncured resin is filled in a cavity defined by a self-stable dam of uncured resin, which are preferably chemically identical, but can be different regarding optical and mechanical characteristics (as the material of the outer dam 2 is provided with different "additives" as the material of the central filling 3).

The chemical identity has to be such that the material used for the dam and the filling, respectively, can be cured using the same curing mechanism in order to produce a chemical linking across the interface between the two materials.

The filling material entirely covers the top surface of the LED die 1. It also covers the space between the LED die 1 and the walls of the dam 2 (if any) and contacts the board 4 in this gap between the LED die 1 and the dam 2.

The transparent material for the central filling 3 is made from a silicone material. Preferably, the resin for the central filling 3 is made from the same material as the resin for the dam 2 such that these resins are chemically identical.

In accordance with the present invention, white color-conversion LED modules can be provided, in which colour conversion particles are added to the transparent resin material of the central filling 3. The type and the amount of the colour conversion particles depends on the desired colour temperature of the LED module, which is known as such from the prior art. Preferably there is an increasing concentration gradient of the color conversion particles from the top to the bottom of the filling, which can be achieved e.g. by allowing the color conversion particles to sink towards the bottom of the filling.

In a third step the liquid resins i.e. the resins of the central filling 3 and the dam 2 are cured by a single curing cycle such that both of the materials are cured and chemically linked together across their interface.

The above-outlined manufacturing process relies on a relatively high mechanical stability of the material of the wall in the uncured "liquid" state. Again, in order to achieve this mechanical stability in the liquid state, additional filling materials such as for example silica can be added to the resin for the dam 2.

Both for the manufacturing of the dam 2 as well as for the filling a standard computer controlled dispensing equipment can be used.

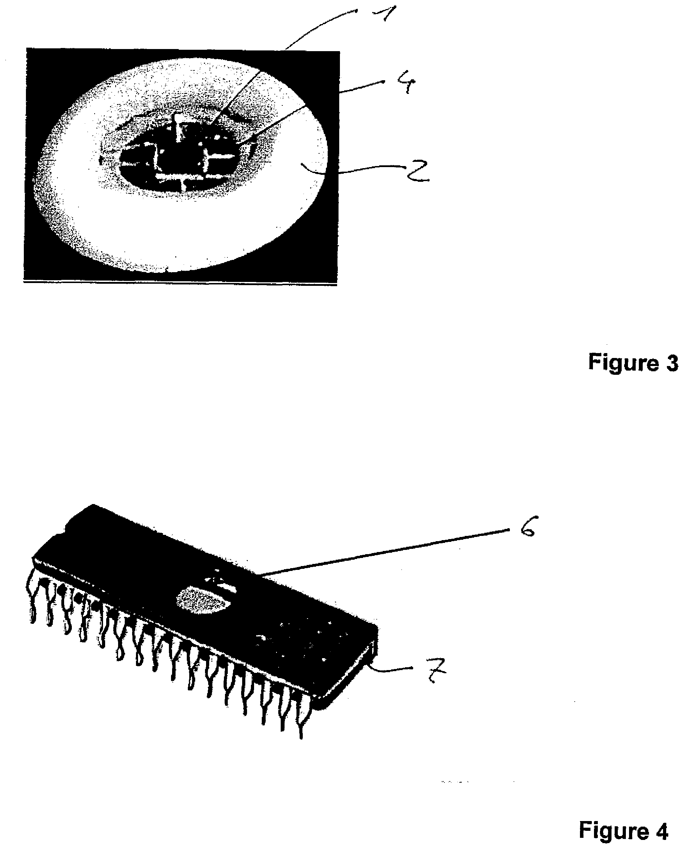

Figures 2 and 3 show a top view (Fig. 2) and a perspective view (Fig. 3) of a LED module according to the present invention comprising a LED chip mounted in chip-on-board technology. In these examples the material of the dam 2 is highly reflective as white pigments have been added throughout the base resin for the dam 2.

On the other hand, the resin for the filling 3 is transparent and the bond wires 5 can be seen which are surrounded and stabilized by the material of the central filling 3.

As will be explained in the following, the LED modules of the present invention can also be used in connection with other electronic or optoelectronic components.

In Fig. 4 a light-erasable memory device such as for example a EEPROM 7 is shown (not forming part of the present invention).

A cover similar to the one used in the LED module of the present invention can protect the opening 6 of the casing of the light erasable memory device 7, which opening is designed for the light erasing process.

Due to the "dam-and-fill" cover, which can be made of highly transparent materials depending on the requirements of the erasing/programming light beam, a protection against environmental influences as well as perfect fit to the erasing/programming light source can be achieved. Especially, the protection against scattered light and stray light is a big advantage of the dam and fill cover. The outer dam thus can not only serve as a reflective element, but additionally or alternatively as an opaque shielding.

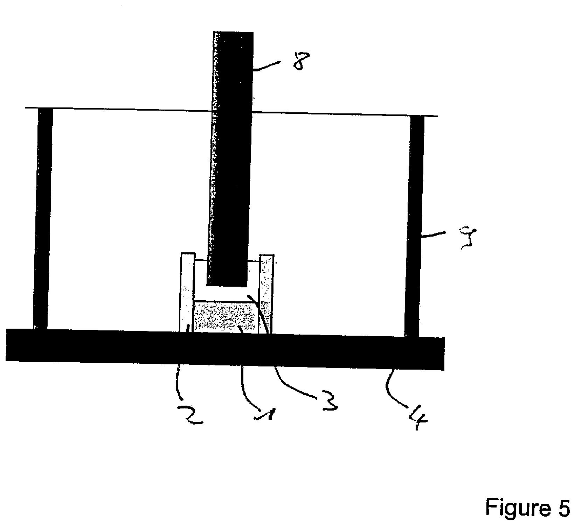

Finally, Fig. 5 shows the use of a LED module according to the present invention in connection with light guides and optical fibers.

The dam material 2 provides a mechanical stability, such that it is possible to provide the filling 3 on top of the LED chip 1 as a very fluid and highly transparent synthetic resin.

In the example shown in Fig. 5 there is no gap between the dam 2 and the LED chip 1 such that the filling material is only present on top of the LED chip 1.

Furthermore, the filling 3 is not completely flush with the top of the wall of the dam 2.

The reference sign 8 designates an optical fiber to which light from the LED chip 1 is to be transmitted (transversing the transparent resin material 3).

The reference sign 9 designates mechanical fixture for optical fibers.

The arrangement as shown in Fig. 5 provides for an improved light feeding from the LED chip 1 to the optical fibre.

## Claims

1. A light-emitting diode module comprising a light-emitting diode chip (1) mounted on a board (4), and a cover,
the cover comprising an outer dam (2) dispensed on the board (4), and a central filling (3), which is filled into the outer dam (2),
wherein the outer dam (2) is made from a cured resin;
wherein the central filling (3) is made from a cured transparent silicone based resin, and wherein the central filling (3) comprises color conversion particles;
**characterized in that**
the outer dam (2) is non-transparent and comprises reflecting particles throughout the bulk of the outer dam material, and
the central filling (3) is chemically linked to the outer dam (2) across the interface between the two materials.

2. The light-emitting diode module according to Claim 1, wherein the resin of the outer dam (2) is silicone based.

3. The light-emitting diode module according to Claim 1 or 2,
wherein the inner wall of the outer dam (2) is distanced from the light-emitting diode chip (1), such that the distance between the outer dam (2) and light-emitting diode chip (1) is filled with the central filling (3) and in contact with the board (4) on which the light-emitting diode chip (1) is mounted.

4. The light-emitting diode module according to any of the preceding claims,
wherein the central filling (3) is filled at least partially on top of the light-emitting diode chip (1).

5. The light-emitting diode module according to any of the preceding claims,
wherein the resin of the outer dam (2) and the central filling (3) have the same chemical structure.

6. The light-emitting diode module according to any of the preceding claims,
wherein the resin of the outer dam (2) and the central filling (3) are chemically identical.

7. The light-emitting diode module according to any of the preceding claims,
wherein the reflecting particles are white pigments from the group of TiO₂, BaTiO₃, BaSO₄ and ZrO₂.

8. The light-emitting diode module according to any of the preceding claims,
wherein the outer dam (2) comprises 10 to 60 weight % of reflecting particles.

9. The light-emitting diode module according to any of the preceding claims, wherein the mean thickness of the outer dam (2) is adjusted to more than 0.5 mm for diameters of the outer dam (2) larger than 5 mm.

10. The light-emitting diode module according to any of the preceding claims,
wherein the light-emitting diode chip (1) is mounted on the board (4) according to a chip-on-board technology.

11. The light-emitting diode module according to any of the preceding claims,
wherein the central filling (3) fills the entire volume defined by the outer dam (2).

12. The light-emitting diode module according to any of the preceding claims,
wherein the outer dam (2) is higher than the light-emitting diode chip (1).

13. The light-emitting diode module according to any of the preceding claims,
wherein the height of the outer dam (2) has at least the height of light-emitting diode chip (1) to be covered.

14. The light-emitting diode module according to any of the preceding claims,
wherein the outer dam (2) has circular, oval, or rectangular shape.

15. The light-emitting diode module according to any of the preceding claims,
wherein the light-emitting diode module comprises a plurality of light-emitting diode chips (1), which are in a row configuration placed inside the outer dam (2).

16. The light-emitting diode module according to any of the preceding claims,
wherein the central filling (3) is made by dispensing.

17. The light-emitting diode module according to any of the preceding claims,
wherein the light-emitting diode module comprises bonding wires (5), which are stabilized by the material of the central filling (3).

18. The light-emitting diode module according to any of the preceding claims,
wherein the board (4) is a plane board without recessions.

19. The light-emitting diode module according to any of the preceding claims,
wherein the cross-section of the outer dam (2) tapers to the peak (10) of the dam (2) and wherein the inner face (11) of the dam (2) is inclined.

20. The light-emitting diode module according to any of the preceding claims, wherein the outer dam (2) comprises particulate material such as e.g. silica.

## Patentansprüche

1. Leuchtdiodenmodul, umfassend einen Leuchtdiodenchip (1), der auf einer Platine (4) montiert ist, und eine Abdeckung,
wobei die Abdeckung einen äußeren Damm (2), der auf der Platine (4) aufgebracht ist, und
eine mittige Füllung (3), die in den äußeren Damm (2) gefüllt ist, umfasst
wobei der äußere Damm (2) aus einem gehärteten Harz besteht;
wobei die mittige Füllung (3) aus einem gehärteten, transparenten Harz auf Silikonbasis besteht, und
wobei die zentrale Füllung (3) Farbumwandlungspartikel umfasst;
**dadurch gekennzeichnet, dass**
der äußere Damm (2) undurchsichtig ist und reflektierende Partikel in der gesamten Masse des Materials des äußeren Damms umfasst, und
die mittige Füllung (3) mit dem äußeren Damm (2) über die Grenzfläche zwischen den beiden Materialien chemisch verbunden ist.

2. Leuchtdiodenmodul nach Anspruch 1,
wobei das Harz des äußeren Damms (2) silikonbasiert ist.

3. Leuchtdiodenmodul nach Anspruch 1 oder 2,
wobei die Innenwand des äußeren Damms (2) von dem Leuchtdiodenchip (1) beabstandet ist,
sodass der Abstand zwischen dem äußeren Damm (2) und dem Leuchtdiodenchip (1) mit der mittigen Füllung (3) ausgefüllt und in Kontakt mit der Platine (4) ist, auf der der Leuchtdiodenchip (1) montiert ist.

4. Leuchtdiodenmodul nach einem der vorhergehenden Ansprüche,
wobei die mittige Füllung (3) zumindest teilweise oben auf den Leuchtdiodenchip (1) aufgefüllt ist.

5. Leuchtdiodenmodul nach einem der vorhergehenden Ansprüche,
wobei das Harz des äußeren Damms (2) und die mittige Füllung (3) die gleiche chemische Struktur aufweisen.

6. Leuchtdiodenmodul nach einem der vorhergehenden Ansprüche,
wobei das Harz des äußeren Damms (2) und die mittige Füllung (3) chemisch identisch sind.

7. Leuchtdiodenmodul nach einem der vorhergehenden Ansprüche,
wobei die reflektierenden Partikel weiße Pigmente aus der Gruppe bestehend aus TiO₂, BaTiO₃, BaSO₄ und ZrO₂ sind.

8. Leuchtdiodenmodul nach einem der vorhergehenden Ansprüche,
wobei der äußere Damm (2) 10 bis 60 Gew.-% reflektierende Partikel umfasst.

9. Leuchtdiodenmodul nach einem der vorhergehenden Ansprüche,
wobei die mittlere Dicke des äußeren Damms (2) für Durchmesser des äußeren Damms (2) von mehr als 5 mm auf mehr als 0,5 mm eingestellt ist.

10. Leuchtdiodenmodul nach einem der vorhergehenden Ansprüche,
wobei der Leuchtdiodenchip (1) gemäß einer Chip-on-Board-Technik auf der Platine (4) montiert ist.

11. Leuchtdiodenmodul nach einem der vorhergehenden Ansprüche,
wobei die mittige Füllung (3) das gesamte durch den äußeren Damm (2) definierte Volumen ausfüllt.

12. Leuchtdiodenmodul nach einem der vorhergehenden Ansprüche,
wobei der äußere Damm (2) höher als der Leuchtdiodenchip (1) ist.

13. Leuchtdiodenmodul nach einem der vorhergehenden Ansprüche,
wobei die Höhe des äußeren Damms (2) mindestens die Höhe des abzudeckenden Leuchtdiodenchips (1) aufweist.

14. Leuchtdiodenmodul nach einem der vorhergehenden Ansprüche,
wobei der äußere Damm (2) eine kreisförmige, ovale oder rechteckige Form aufweist.

15. Leuchtdiodenmodul nach einem der vorhergehenden Ansprüche,
wobei das Leuchtdiodenmodul eine Vielzahl von Leuchtdiodenchips (1) umfasst, die in einer Reihenkonfiguration angeordnet sind, die innerhalb des äußeren Damms (2) platziert ist.

16. Leuchtdiodenmodul nach einem der vorhergehenden Ansprüche,
wobei die mittige Füllung (3) durch Aufbringen hergestellt wird.

17. Leuchtdiodenmodul nach einem der vorhergehenden Ansprüche,
wobei das Leuchtdiodenmodul Bonddrähte (5) umfasst, die durch das Material der mittigen Füllung (3) stabilisiert werden.

18. Leuchtdiodenmodul nach einem der vorhergehenden Ansprüche,
wobei die Platine (4) eine ebene Platine ohne Vertiefungen ist.

19. Leuchtdiodenmodul nach einem der vorhergehenden Ansprüche,
wobei sich der Querschnitt des äußeren Damms (2) zu der Spitze (10) des Damms (2) hin verjüngt, und wobei die Innenseite (11) des Damms (2) geneigt ist.

20. Leuchtdiodenmodul nach einem der vorhergehenden Ansprüche,
wobei der äußere Damm (2) Partikelmaterial wie z. B. Siliciumdioxid umfasst.

## Revendications

1. Module de diode électroluminescente comprenant une puce de diode électroluminescente (1) montée sur une carte (4) et un recouvrement,
le recouvrement comprenant un barrage extérieur (2) réparti sur la carte (4), et
un remplissage central (3), qui est rempli dans le barrage extérieur (2),
dans lequel le barrage extérieur (2) est fabriqué à partir d'une résine durcie ;
dans lequel le remplissage central (3) est fabriqué à partir d'une résine à base de silicone transparente durcie, et
dans lequel le remplissage central (3) comprend des particules de conversion de couleur ;
**caractérisé en ce que**
le barrage extérieur (2) est non transparent et comprend des particules réfléchissantes sur la plus grande partie du matériau de barrage extérieur, et
le remplissage central (3) est chimiquement lié au barrage extérieur (2) à travers l'interface située entre les deux matériaux.

2. Module de diode électroluminescente selon la revendication 1,
dans lequel la résine du barrage extérieur (2) est à base de silicone.

3. Module de diode électroluminescente selon la revendication 1 ou 2,
dans lequel la paroi interne du barrage extérieur (2) est à distance de la puce de diode électroluminescente (1),
de telle sorte que la distance entre le barrage extérieur (2) et la puce de diode électroluminescente (1) est remplie avec le remplissage central (3) et en contact avec la carte (4) sur laquelle la puce de diode électroluminescente (1) est montée.

4. Module de diode électroluminescente selon l'une quelconque des revendications précédentes,
dans lequel le remplissage central (3) est rempli au moins partiellement sur le haut de la puce de diode électroluminescente (1).

5. Module de diode électroluminescente selon l'une quelconque des revendications précédentes,
dans lequel la résine du barrage extérieur (2) et le remplissage central (3) ont la même structure chimique.

6. Module de diode électroluminescente selon l'une quelconque des revendications précédentes,
dans lequel la résine du barrage extérieur (2) et le remplissage central (3) sont chimiquement identiques.

7. Module à diode électroluminescente selon l'une quelconque des
revendications précédentes,
dans lequel les particules réfléchissantes sont des pigments blancs appartenant au groupe constitué de TiO₂, BaTiO₃, BaSO₄ et ZrO₂.

8. Module à diode électroluminescente selon l'une quelconque des
revendications précédentes, dans lequel la barrière extérieure (2) comprend de 10 à 60 % en poids de particules réfléchissantes.

9. Module de diode électroluminescente selon l'une quelconque des revendications précédentes, dans lequel l'épaisseur moyenne du barrage extérieur (2) est ajustée à plus de 0,5 mm pour les diamètres du barrage extérieur (2) supérieurs à 5 mm.

10. Module de diode électroluminescente selon l'une quelconque des
revendications précédentes,
dans lequel la puce de diode électroluminescente (1) est montée sur la carte (4) selon une technologie de puce sur plaque.

11. Module à diode électroluminescente selon l'une quelconque des
revendications précédentes,
dans lequel le remplissage central (3) remplit le volume entier défini par le barrage extérieur (2).

12. Module à diode électroluminescente selon l'une quelconque des
revendications précédentes,
dans lequel la barrière extérieure (2) est plus haute que la puce à diode électroluminescente (1).

13. Module de diode électroluminescente selon l'une quelconque des
revendications précédentes,
dans lequel la hauteur du barrage extérieur (2) a au moins la hauteur de la puce de diode électroluminescente (1) à couvrir.

14. Module de diode électroluminescente selon l'une quelconque des
revendications précédentes,
dans lequel le barrage extérieur (2) a une forme circulaire, ovale ou rectangulaire.

15. Module de diode électroluminescente selon l'une quelconque des
revendications précédentes,
dans lequel le module de diode électroluminescente comprend une pluralité de puces de diode électroluminescente (1), qui sont en une configuration de rangée placée à l'intérieur du barrage extérieur (2).

16. Module à diode électroluminescente selon l'une quelconque des revendications précédentes, dans lequel le remplissage central (3) est fait par répartition.

17. Module de diode électroluminescente selon l'une quelconque des revendications précédentes,
dans lequel le module de diode électroluminescente comprend des fils de liaison (5), qui sont stabilisés par le matériau du remplissage central (3).

18. Module de diode électroluminescente selon l'une quelconque des revendications précédentes, dans lequel la carte (4) est une carte plane sans récession.

19. Module de diode électroluminescente selon l'une quelconque des revendications précédentes,
dans lequel la section transversale du barrage extérieur (2) se rétrécit jusqu'au sommet (10) du barrage (2) et dans lequel la face intérieure (11) du barrage (2) est inclinée.

20. Module de diode électroluminescente selon l'une quelconque des
revendications précédentes,
dans lequel le barrage extérieur (2) comprend des particules de matière telles que, par exemple, de silice.
